# EUROPEAN PATENT APPLICATION

(11) **EP 4 588 397 A1**
(43) Date of publication of application: **23.07.2025**
(21) Application number: 25151818.9
(22) Date of filing: 14.01.2025
(51) Int. Cl.: A46B 11/00, A46B 13/00, B08B 1/12, B08B 1/32, H01L 21/67

(54) **BRUSHES AND SYSTEMS WITH IMPROVED BRUSH MANDRELS**

(30) Priority: 16.01.2024 US 202463621317 P; 15.11.2024 US 202418949154
(71) Applicant: Illinois Tool Works Inc., Glenview IL 60025 (US)
(72) Inventor: NELSON, Erik, Glenview, 60025 (US)
(74) Representative: HGF

(57) **Abstract**

An example brush for cleaning of a substrate with a fluid, the brush comprising a polymeric brush body comprising one or more contact surfaces for cleaning the substrate, a mandrel configured to support the polymeric brush body and comprising a plurality of apertures distributed over a surface of the mandrel, and a bore configured to supply the polymeric brush body with fluid via the plurality of apertures, the bore having a diameter sufficient to supply the plurality of apertures with substantially uniform aperture flow rates.

## Description

### CROSS REFERENCE TO RELATED APPLICATIONS

This application claims priority to, and the benefit of, U.S. Provisional Patent Application No. 63/621,317, entitled "Brushes and Systems for Improved Brush Mandrels," filed January 16, 2024, the entire content of which being hereby incorporated by reference.

### FIELD OF THE DISCLOSURE

The present disclosure relates to substrate-cleaning brushes, and more particularly, to brushes and systems with improved brush mandrels.

### BACKGROUND

In the semiconductor manufacturing industry and other industries, brushes are used to remove contaminants from surfaces, such as from semiconductor wafers. Depending on the specific application, cleaning of a substrate or surface may also involve delivery of one or more substances or fluids (e.g., chemicals, ultra-pure water (UPW), deionized water (DIW), etc.) to the substrate or surface through the mandrel of the brush. Variability in flow of the one or more substances through the mandrel may negatively impact the removal of contaminants from surfaces and/or may impact the cleaning of the substrate or surface.

Limitations and disadvantages of conventional approaches will become apparent to one of skill in the art, through comparison of such approaches with some aspects of the present method and system set forth in the remainder of this disclosure with reference to the drawings.

### SUMMARY

Brushes and systems with improved brush mandrels are disclosed, substantially as illustrated by and described in connection with at least one of the figures, as set forth more completely in the claims.

### BRIEF DESCRIPTION OF THE DRAWINGS

These and/or other aspects will become apparent and more readily appreciated from the following description of the exemplary embodiments, taken in conjunction with the accompanying drawings.
FIG. 1 is a schematic diagram of an example system to clean a substrate, in accordance with aspects of this disclosure.
FIG. 2A is a detailed view of an example mandrel, in accordance with aspects of this disclosure.
FIG. 2B is a longitudinal cross-sectional view of the example mandrel of FIG. 2A along line 2B-2B, in accordance with aspects of this disclosure.
FIG. 3A is a side view of an example mandrel fastener, in accordance with aspects of this disclosure.
FIG. 3B is an end view of the example mandrel fastener of FIG. 3A, in accordance with aspects of this disclosure.
FIG. 3C is a cross-sectional view of the example mandrel fastener of FIG. 3A along line 3C-3C, in accordance with aspects of this disclosure.
FIG. 4 is a cross-sectional view of an example mandrel with an example mandrel fastener installed, in accordance with aspects of this disclosure.

The figures are not necessarily to scale. Where appropriate, similar or identical reference numbers are used to refer to similar or identical components.

### DETAILED DESCRIPTION

Various applications and processes may benefit from physical cleaning of a surface. For example, in semiconductor manufacturing, a semiconductor wafer may be cleaned to remove potentially destructive contaminants during one or more stages of fabricating electronic circuits on the wafer. The cleaning can be provided by, for example, a brush that comes in contact with the surface to be cleaned.

To efficiently clean a substrate, disclosed example brushes come into contact with a substrate to be cleaned in the presence of a substance or fluid. Disclosed example brushes are either mounted or cast directly to rotatable hollow bases or mandrels, with holes that allow substances to flow through the base or mandrel, into and through the brush body, and onto the substrate or surface to be cleaned.

The inventors have discovered a set of designs for a brush that provides a more uniform distribution of chemical(s) and/or water from the mandrel and/or brush to the substrate, thereby improving the cleaning ability of the brush. Example brush mandrels may be configured to provide a uniform flow of chemical(s) or water, such as DIW or UPW, through the mandrel bore for improve cleaning of substrates. Example mandrels may be configured to provide a constant pressure through an internal bore of the mandrel.

Disclosed example brushes and/or brush mandrels provide a more uniform flow of one or more substrates and/or fluids to reduce pressurization and leaking from the mandrel, compared with conventional brushes and/or brush mandrels. Example mandrels are configured to provide a uniform flow rate for an even distribution of chemicals and/or water across the brush body for more efficient substrate cleaning. Example mandrels may be configured to provide uniform flow rates using originally manufactured equipment.

Disclosed example brushes for cleaning of a substrate with a fluid include a polymeric brush body. The polymeric brush body includes one or more contact surfaces for cleaning the substrate. Disclosed example brushes also includes a mandrel configured to support the polymeric brush body and include a plurality of apertures distributed over a surface of the mandrel. The brush also includes a bore configured to supply the polymeric brush body with fluid via the plurality of apertures, the bore having a diameter sufficient to supply the plurality of apertures with substantially uniform aperture flow rates for bore flow rates between 200 ml/min and 2 L/min.

In some example brushes, the polymeric brush body is substantially cylindrical and the one or more contact surfaces may include a plurality of nodules extending from an outer surface of the cylindrical brush body. In some example brushes, the diameter of the bore is between .7 inch and . 8 inch. In some examples, the diameter of the bore is larger than a diameter of a fastener configured to attach the mandrel to a support arm.

In some example brushes, the mandrel is configured to distribute the fluid to the polymeric brush body through the plurality of apertures at a substantially constant pressure between different ones of the plurality of apertures. In some example brushes, the bore is configured to provide the fluid at less than a predetermined pressure gradient from a first end of the mandrel to a second end of the mandrel. The polymeric brush body may include at least one of a polyvinyl acetal foam, a polyurethane foam, a polyolefin foam, a porous fluoropolymer, a silicone foam, a polyester foam, a nylon foam, or a polyacrylic foam.

In some example brushes, the polymeric brush body is molded over a brush support, assembled, and then mounted on the brush support, or assembled as a sponge-only brush. Some example brushes include a brush support configured to rotate the polymeric brush body about an axis of the polymeric brush body and a fastener configured to fasten the mandrel to the brush support.

In some example brushes, the fastener is a clasp, a clip, or a threaded connector. The fastener may be arranged between the mandrel and the brush support and may include a smaller diameter at a first end that interfaces with the mandrel than a second end that interfaces with the brush support. The fastener may include an inner diameter that is smaller than an inner diameter of the mandrel.

Disclosed systems to clean a substrate include a cleaning brush, a polymeric brush body including one or more contact surfaces for cleaning the substrate, and a mandrel configured to support the polymeric brush body. The mandrel may include a plurality of apertures distributed over a surface of the mandrel and a bore configured to supply the polymeric brush body with fluid via the plurality of apertures, the bore having a diameter sufficient to supply the plurality of apertures with substantially uniform aperture flow rates for bore flow rates between 200 ml/min and 2 L/min. Disclosed systems also include a brush support configured to rotate the polymeric brush body about an axis of the polymeric brush body. Disclosed systems also include a fastener configured to connect the mandrel to the brush support. Disclosed systems also include an actuator coupled to the fastener and configured to rotate the polymeric brush body along the axis of the polymeric brush body via the brush support.

In some example systems, the polymeric brush body is substantially cylindrical and the one or more contact surfaces may include a plurality of nodules extending from an outer surface of the cylindrical brush body. In some example systems, the mandrel is configured to distribute the fluid to the polymeric brush body through the plurality of apertures at less than a predetermined pressure gradient between different ones of the plurality of apertures. In some example systems, the bore is configured to provide the fluid at less than a predetermined pressure gradient from a first end of the mandrel to a second end of the mandrel.

In some example systems, the polymeric brush body may include at least one of a polyvinyl acetal foam, a polyurethane foam, a polyolefin foam, a porous fluoropolymer, a silicone foam, a polyester foam, a nylon foam, or a polyacrylic foam. In some example systems, the polymeric brush body is molded over the brush support, assembled and then mounted on the brush support, or assembled as a sponge-only brush.

In some example systems, the fastener is a clasp, a clip, or a threaded connector. In some example systems, the fastener is arranged between the mandrel and the brush support and may include a smaller diameter at a first end that interfaces with the mandrel than a second end that interfaces with the brush support. In some example systems, the fastener may include an inner diameter that is smaller than an inner diameter of the mandrel.

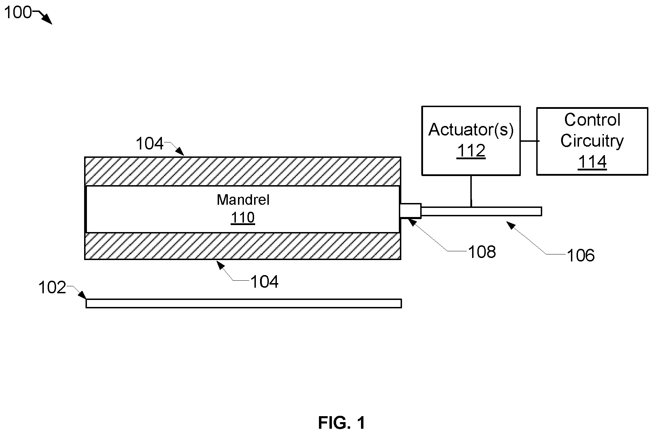

FIG. 1 is a schematic diagram of an example system 100 to clean a substrate 102. The example system 100 includes a brush body 104 with an interior mandrel 110, a support arm 106, a mandrel fastener 108, and one or more actuators 112 controlled via control circuitry 114. In some examples, the example system 100 dispenses fluid through the mandrel 110 to the brush body 104 during a cleaning of the substrate 102.

In the example of FIG. 1, the support arm 106 is shown coupled to the mandrel 110 via the mandrel fastener 108. The support arm 106 positions the brush body 104 relative to the substrate 102. The mandrel fastener 108 couples the mandrel 110 to the support arm 106 and one or more actuator(s) 112. In some examples, the actuator(s) 112 move and/or rotate the brush body 104 with respect to the substrate 102 via the support arm 106.

In the example of FIG. 1, the example system 100 includes control circuitry 114 configured to control the actuator(s) 112. In some examples, the control circuitry 114 controls the actuator(s) 112 based on a desired cleaning process. For example, the control circuitry 114 may control movement and/or rotation of the brush body 104 by controlling the actuators 112 to move the brush body 104 into and/or out of contact with the substrate 102, to move the brush body 104 relative to the substrate 102 (e.g., if the substrate 102 is in motion), and/or to rotate the brush body 104 along an axis of rotation (e.g., via the mandrel 110 and/or support arm 106).

In some examples, the example control circuitry 114 includes at least one controller and/or processor that controls the operations of the actuator(s) 112 and/or system 100. In some examples, the control circuitry 114 receives and processes multiple inputs associated with the performance and demands of the system 100.

In some examples, the control circuitry 114 may include one or more microprocessors, such as one or more "general-purpose" microprocessors, one or more special-purpose microprocessors and/or ASICS, and/or any other type of processing device. For example, the control circuitry 114 may include one or more digital signal processors (DSPs). The example control circuitry 114 may further include one or more storage device(s) (e.g., ROM, flash memory, a hard drive, and/or any other suitable optical, magnetic, and/or solid-state storage medium, and/or a combination thereof) and one or more memory device(s) (e.g., volatile and/or non-volatile memory). In some examples, under control of the control circuitry 114, the actuator(s) 112 may move and/or rotate the support arm 106, and thereby move and/or rotate the mandrel 110.

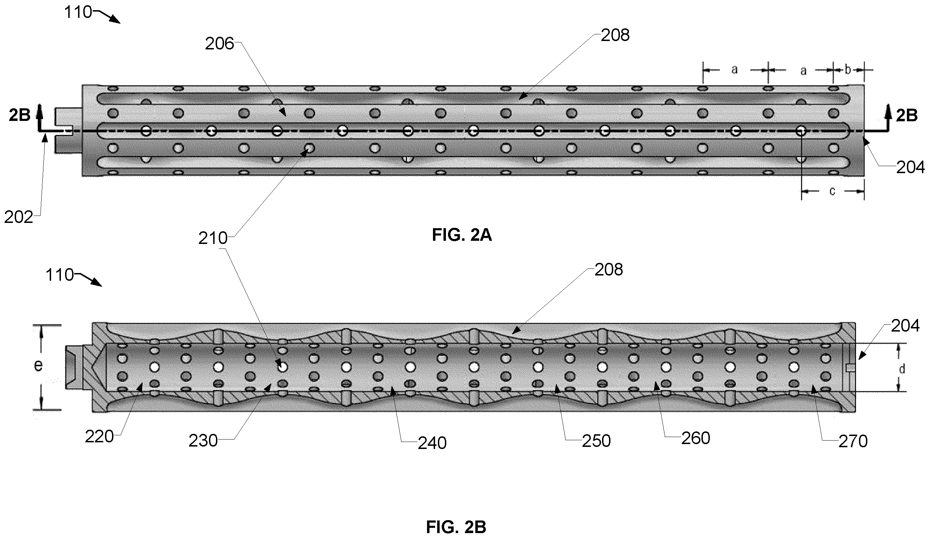

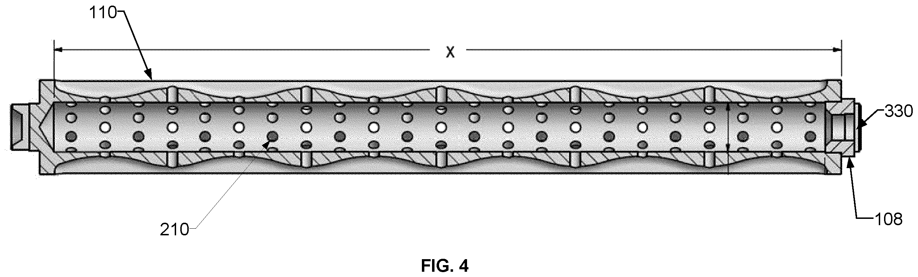

In the example of FIG. 1, the mandrel 110 is substantially cylindrical (e.g., including cylindrical shapes having contiguous cylindrical surfaces, as well as cylindrical shapes in which the cylindrical surface and/or corresponding circular cross-section are interrupted by protrusions (e.g., ridges) and/or recesses (e.g., grooves)). As shown, the mandrel 110 is located within the brush body 104. In some examples, the mandrel 110 includes a hollow bore (described below with regards to FIGS. 2A, 2B, and 4) which delivers one or more substrates and/or fluids to the brush body 104. In some examples, the mandrel 110 further supports the brush body and/or engages the brush body 104 in order to allow the brush body to move with the mandrel 110 as the mandrel 110 is moved and/or rotated by the support arm 106 and/or the actuator(s) 112.

In some examples, the mandrel 110 may be rotated to impart rotation on the brush body 104 with respect to the substrate 102. In some examples, the substrate 102 may be supported on a platen or other support surface. In some examples, the substrate 102 is rotated by the platen in a different rotational direction as the rotation of the brush body 104 during the cleaning process.

In some examples, the substrate 102 may be conveyed in a linear direction, with or without rotation of the substrate 102. In some examples, during a cleaning process, the substrate 102 may be placed between the mandrel 110 and/or brush body 104 and an additional mandrel and/or brush body. In some examples, the substrate 102, the brush body/bodies 104, and/or the mandrel(s) 104 may be rotated during the cleaning process.

In the example of FIG. 1, the example brush body 104 is shown as being substantially cylindrical (e.g., including cylindrical shapes having completely contiguous cylindrical surfaces, as well as cylindrical shapes in which the cylindrical surface and/or corresponding circular cross-section are interrupted by protrusions (e.g., protruding nodules) and/or recesses (e.g., grooves)). In the example of FIG. 1, the mandrel 110 and brush body 104 have a longer axial dimension (e.g., length) than the radial dimension (e.g., diameter). In some examples, the brush body 104 may be smooth or may comprise nodules for cleaning the substrate 102.

In some examples, the brush body 104 may be a porous polymeric foam. In some examples, the porous polymeric foam of the brush body 104 may be molded, machined, constructed using additive manufacturing techniques, and/or otherwise constructed in an annular and/or cylindrical shape and attached to the mandrel 110. Example polymeric foams that may be used to implement the brush and/or brush body 104 include, but are not limited to, polyvinyl acetate foams, polyurethane foams, polyolefin foams, porous fluoropolymers, silicone foams, polyester foams, nylon foams, and/or polyacrylic foams.

In some examples, the brush body 104 may be formed by casting the porous polymeric foam directly on the mandrel 110. In some examples, the porous polymeric foam may be formed as a brush body 104 and then assembled and/or mounted onto the mandrel 110. In some examples, the brush body 104 is a porous polymer brush and manufactured as a sponge-only brush.

In examples where the brush body 104 is porous, the fluid from the mandrel 110 is able to disperse through the brush body 104, and eventually reach the substrate 102 for cleaning. In some examples, the support arm 106 delivers fluids and/or substances to the brush body 104 (e.g., via the mandrel 110). In some examples, the support arm 106 includes originally manufactured equipment, and the mandrel fastener 108 is configured to attach the mandrel 110 to the originally manufactured equipment.

FIG. 2A is a detailed view of an example mandrel 110, in accordance with aspects of this disclosure. As shown, the mandrel 110 is substantially cylindrical and is centered about a central axis 202 that extends through the center of the mandrel 110. The mandrel 110 is further shown as including a substantially cylindrical hollow bore 204, which is also centered about the central axis 202.

In the example of FIG. 2A, the mandrel 110 comprises raised portions 206 and grooves 208 along all or most of the length of the mandrel 110. The raised portions 206 and grooves 208 are shown evenly spaced on the surface of the mandrel 110. The grooves 208 are further shown as extending parallel to the central axis 202.

In some examples, the raised portions 206 and/or grooves 208 may engage the brush body 104 (described above with reference to FIG. 1) to allow the brush body 104 to be supported and/or rotated by the mandrel 110. In some examples, the raised portions 206 and/or grooves 208 may be curvilinear along the length of the mandrel 110, as shown and/or described further below with regards to FIG. 2B.

In the example of FIG. 2A, the raised portions 206 and grooves 208 include openings 210. As shown, the openings 210 are evenly spaced around the mandrel 110 on each of raised portions 206 and grooves 208, at approximately distance a from one another. In some examples, distance a is between 1 and 1.05 inches. In some examples, distance a is approximately 1.02 inches.

In the example of FIG. 2A, the openings 210 located on the raised portions 206 are a distance b from one or more edges of the mandrel 110. As shown, the openings 210 located on the grooves 208 are located a distance c from one or more edges of the mandrel 110. In some examples, distance b is between .45 and .5 inch, and distance c is between .97 and .98 inch. In some examples, distance b may be .47 inch and distance c may be .975 inch.

In some examples, the openings 210 on the raised portions 206 may be staggered and/or oriented relative to the openings 210 on the grooves 208. In some examples, the spacing of the openings 210 may provide a uniform flow and pressure rate to the brush body 104 from the bore 204 for fluids traveling through the bore 204 at flow rates between 200 mL/min to 2 L/min. For example, the openings 210 may provide substantially uniform flow rates through the length of the bore as described further below with regards to FIG. 2B.

FIG. 2B is a longitudinal cross-sectional view of the example mandrel 110 of FIG. 2A FIG. 2B shows the bore 204 running through the center of the mandrel 110.

As shown, an inner wall of the mandrel 110 that encircles and/or defines the bore 204 includes the aforementioned openings 210. As shown, the openings 210 are approximately circular, with a central axis of each opening extending approximately perpendicular to the central axis 202 of the mandrel 110. In some examples, other shapes, sizes, and/or spacing of the openings 210 may be used.

In the example of FIG. 2B, the bore 204 has a diameter d. In some examples diameter d is larger than .38 inch. In some examples, the diameter d is between .754 and .758 inch and/or has a ratio of between .5 and .57 relative to the diameter e of the mandrel 110. In some examples, the diameter e of the mandrel is between 1.4 and 1.45 inches. In some examples, the diameter e of the mandrel is approximately 1.412 inches. In some examples, the diameter d of the bore 204 serves to provide uniform flow rate and constant pressure along the length of the bore for fluid flow rates from 200 mL/min to 2 L/min.

In some examples, the configuration of the bore 204 enables fluid to be supplied to the mandrel 110 and/or brush body 104 at a substantially uniform flow rate throughout the length of the bore 204. In the example of FIG. 2B, the bore 204 is shown as being comprised of several different sections 220, 230, 240, 250, 260, and 270 along the length of the bore 204. In some examples, the configuration of the bore 204 enables fluid to be supplied through the different sections 220, 230, 240, 250, 260, 270 along the length of the bore 204 at substantially uniform fluid flow rates (e.g., where a flow rate in a particular section has a maximum 20% deviation from a flow rate in any other section).

For example, for a flow rate of 500 mL/min and five sections of mandrel 110, each section may provide 100 mL of fluid per minute, with a deviation not exceeding 20% (e.g., between 80 and 120 mL/min). Although an example of five sections is provided, a different number of sections may be used to measure flow rates.

In some examples, the bore 204 of the mandrel 110 provides fluid at a substantially uniform flow rate to the openings 210 of the mandrel 110, which in turn provide the fluid to the brush body 104 surrounding the mandrel 110. In some examples, the fluid rate through the openings 210 is distributed approximately evenly and/or equally through each of the openings 210 (e.g., with a maximum deviation of 20%). For example, for a flow rate of 200 mL/min through the bore 204, each of the openings may have an equal flow rate (e.g. 200 mL/n).

In some examples, the diameter d of the bore 204 relative to the diameter e of the mandrel 110 and/or the number of openings 210 serves to regulate the flow (and/or flow rate) of fluids through the bore 204. In some examples, the relative diameters of the bore 204 and mandrel 110 serve to maintain a uniform flow rate along the length and/or sections of the bore 204. In some examples, the uniform flow rate enables more efficient and/or consistent cleaning of substrates 102.

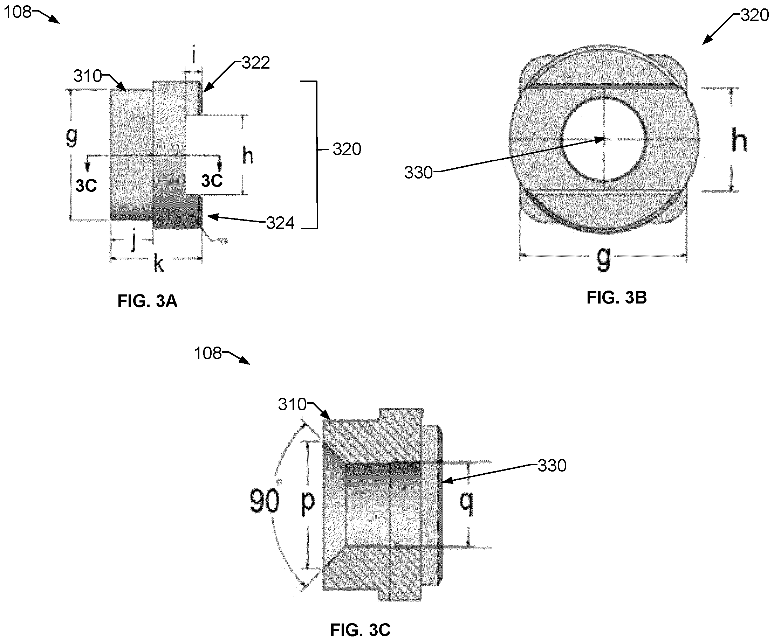

FIGS. 3A-3C show views of an example mandrel fastener 108. As shown, the mandrel fastener 108 includes a first end and a second end. FIG. 3A is a side view of the example mandrel fastener 108. FIG. 3B is an end view of the example mandrel fastener of FIG. 3A at the second end 320 of the example mandrel fastener 108. FIG. 3C is a cross-sectional view of the example mandrel fastener of FIG. 3A.

In some examples, the mandrel fastener 108 provides a fastening mechanism for the mandrel 110 to be attached to the support arm 106 described above with regards to FIG. 1. In some examples, the mandrel fastener 108 may alternatively, or additionally, be a clasp, a clip, and/or a threaded connector.

In the examples of FIGS. 3A-3C, the mandrel fastener 108 includes a first end 310 and a second end 320 with a hollow center 330. The first end 310 is shown as having a different diameter than the second end 320. In particular, the first end 310 is shown as having a diameter g. In some examples, the diameter g is between .765 inch and .775 inch. In some examples, the diameter g is between .77 and .772 inch.

The mandrel fastener 108 is shown as including a hollow center 330 which allows fluids and/or substrates to flow from (and/or through) the support arm 106 and/or through the mandrel fastener 108 and into the bore 204 of the mandrel 110. In some examples, the hollow center 330 has a diameter p at the first end 310. The diameter p may be between .55 and .6 inch. In some examples, the diameter p is .58 inch. In some examples, the hollow center 320 has a diameter q at the second end. The diameter q may be .37 and .4 inch. In some examples, the diameter q is .38 inch. In some examples, the diameter q is smaller than the diameter d of the bore described above with regards to FIG. 2B.

In some examples, the first end 310 of the mandrel fastener 108 may be inserted in the mandrel 110 to attach the mandrel 110 to the support arm 106. In some examples, the second end 320 of the mandrel fastener 108 may be inserted in the support arm 106. In some examples, when inserted into the mandrel 110, a first ledge 322 and a second ledge 324 of the mandrel fastener 108 may engage with the mandrel 110 in order to secure the mandrel 110 to the support arm 106 and allow the mandrel 110 to be rotated by the support arm 106.

In some examples, the first ledge 322 and the second ledge 324 have a length i of between .09 and .15 inch. In some examples, the length i is .098 inch. In some examples, the first ledge 322 may be a distance h from the second ledge 324. In some examples, the distance h may be approximately .470 inch to .480 inch. In some examples, the length h may be .472 inch to .476 inch.

FIG. 4 is a cross-sectional view of an example mandrel 110 with an example mandrel fastener 108 installed, in accordance with aspects of this disclosure. In some examples, length x including bore 204 of the mandrel 110 and the hollow center 330 of the mandrel fastener 108 within the mandrel 110 is between 275 and 330 millimeters. In some examples, length x is approximately 303.5 millimeters. In some examples, the fluid or substrate travels through the hollow center 330 of the mandrel fastener 108 into the hollow bore 204 and through the openings 210 to provide the fluid to the brush body 104 surrounding the mandrel 110 in order to provide uniform flow rates and/or constant pressure through the bore 204 from the mandrel fastener 108 through the bore 204 of the mandrel 110 to the end opposite the mandrel fastener 108.

The disclosed substrate cleaning system 100 enables a more uniform distribution of cleaning fluid to be provided to the bore 204, brush body 104, and/or substrate 102. In some examples, this more uniform distribution of fluid improves the ability of the brush body 104 and/or system 100 to clean the substrate 102.

The present methods and systems may be realized in hardware, software, and/or a combination of hardware and software. The present methods and/or systems may realize, for example, the control circuitry 114 in a centralized fashion in at least one computing system, or in a distributed fashion where different elements are spread across several interconnected computing systems. Any kind of computing system or other apparatus adapted for carrying out the methods described herein is suited. A typical combination of hardware and software may include a general-purpose computing system with a program or other code that, when being loaded and executed, controls the computing system such that it carries out the methods described herein. Another typical implementation may comprise one or more application specific integrated circuit or chip. Some implementations may comprise a non-transitory machine-readable (e.g., computer readable) medium (e.g., FLASH memory, optical disk, magnetic storage disk, or the like) having stored thereon one or more lines of code executable by a machine, thereby causing the machine to perform processes as described herein. As used herein, the term "non-transitory machine-readable medium" is defined to include all types of machine readable storage media and to exclude propagating signals.

As utilized herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As utilized herein, "and/or" means any one or more of the items in the list joined by "and/or." As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g." and "for example" set off lists of one or more non-limiting examples, instances, or illustrations. As utilized herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, the present method and/or system are not limited to the particular implementations disclosed. Instead, the present method and/or system will include all implementations falling within the scope of the appended claims, both literally and under the doctrine of equivalents.
Certain embodiments of the invention are described in the following clauses:
Clause 1. A brush for cleaning of a substrate with a fluid, the brush comprising:
   a polymeric brush body comprising one or more contact surfaces for cleaning the substrate; and
   a mandrel configured to support the polymeric brush body, the mandrel comprising:
      a plurality of apertures distributed over a surface of the mandrel, and
      a bore configured to supply the polymeric brush body with fluid via the plurality of apertures, the bore having a diameter sufficient to supply the plurality of apertures with substantially uniform aperture flow rates for bore flow rates between 200 mL/min and 2 L/min.
Clause 2. The brush as defined in clause 1, wherein the polymeric brush body is substantially cylindrical and the one or more contact surfaces comprise a plurality of nodules extending from an outer surface of the cylindrical brush body.
Clause 3. The brush as defined in clause 1, wherein the diameter of the bore is larger than a diameter of a fastener configured to attach the mandrel to a support arm.
Clause 4. The brush as defined in clause 1, wherein the mandrel is configured to distribute the fluid to the polymeric brush body through the plurality of apertures at a substantially constant pressure between different ones of the plurality of apertures.
Clause 5. The brush as defined in clause 1, wherein the bore is configured to provide the fluid at less than a predetermined pressure gradient from a first end of the mandrel to a second end of the mandrel.
Clause 6. The brush as defined in clause 1, wherein the polymeric brush body comprises at least one of a polyvinyl acetal foam, a polyurethane foam, a polyolefin foam, a porous fluoropolymer, a silicone foam, a polyester foam, a nylon foam, or a polyacrylic foam.
Clause 7. The brush as defined in clause 1, wherein the polymeric brush body is molded over a brush support, assembled, and then mounted on the brush support, or assembled as a sponge-only brush.
Clause 8. The brush as defined in clause 1, further comprising a brush support configured to rotate the polymeric brush body about an axis of the polymeric brush body and a fastener configured to fasten the mandrel to the brush support.
Clause 9. The brush as defined in clause 8, wherein the fastener is a clasp, a clip, or a threaded connector.
Clause 10. The brush as defined in clause 8, wherein the fastener is arranged between the mandrel and the brush support and comprises a smaller diameter at a first end that interfaces with the mandrel than the diameter of the bore.
Clause 11. The brush as defined in clause 8, wherein the fastener comprises an inner diameter that is smaller than an inner diameter of the mandrel.
Clause 12. A system to clean a substrate, the system comprising:
   a cleaning brush, comprising:
      a polymeric brush body comprising one or more contact surfaces for cleaning the substrate,
      a mandrel configured to support the polymeric brush body, the mandrel comprising:
         a plurality of apertures distributed over a surface of the mandrel, and
         a bore configured to supply the polymeric brush body with fluid via the plurality of apertures, the bore having a diameter sufficient to supply the plurality of apertures with substantially uniform aperture flow rates for bore flow rates between 200 mL/min and 2 L/min;
   a brush support configured to rotate the polymeric brush body about an axis of the polymeric brush body;
   a fastener configured to connect the mandrel to the brush support; and
   an actuator coupled to the fastener and configured to rotate the polymeric brush body along the axis of the polymeric brush body via the brush support.
Clause 13. The system as defined in clause 12, wherein the polymeric brush body is substantially cylindrical and the one or more contact surfaces comprise a plurality of nodules extending from an outer surface of the cylindrical brush body.
Clause 14. The system as defined in clause 12, wherein the mandrel is configured to distribute the fluid to the polymeric brush body through the plurality of apertures at less than a predetermined pressure gradient between different ones of the plurality of apertures.
Clause 15. The system as defined in clause 12, wherein the bore is configured to provide the fluid at less than a predetermined pressure gradient from a first end of the mandrel to a second end of the mandrel.
Clause 16. The system as defined in clause 12, wherein the polymeric brush body comprises at least one of a polyvinyl acetal foam, a polyurethane foam, a polyolefin foam, a porous fluoropolymer, a silicone foam, a polyester foam, a nylon foam, or a polyacrylic foam.
Clause 17. The system as defined in clause 12, wherein the polymeric brush body is molded over the brush support, assembled and then mounted on the brush support, or assembled as a sponge-only brush.
Clause 18. The system as defined in clause 12, wherein the fastener is a clasp, a clip, or a threaded connector.
Clause 19. The system as defined in clause 12, wherein the fastener is arranged between the mandrel and the brush support and comprises a smaller diameter at a first end that interfaces with the mandrel than a second end that interfaces with the brush support.
Clause 20. The system as defined in clause 12, wherein the fastener comprises an inner diameter that is smaller than an inner diameter of the mandrel.

## Claims

1. A brush for cleaning of a substrate with a fluid, the brush comprising:
a polymeric brush body comprising one or more contact surfaces for cleaning the substrate; and
a mandrel configured to support the polymeric brush body, the mandrel comprising:
a plurality of apertures distributed over a surface of the mandrel, and
a bore configured to supply the polymeric brush body with fluid via the plurality of apertures, the bore having a diameter sufficient to supply the plurality of apertures with substantially uniform aperture flow rates for bore flow rates between 200 mL/min and 2 L/min.

2. The brush as defined in claim 1, wherein the polymeric brush body is substantially cylindrical and the one or more contact surfaces comprise a plurality of nodules extending from an outer surface of the cylindrical brush body.

3. The brush as defined in claim 1, wherein the diameter of the bore is larger than a diameter of a fastener configured to attach the mandrel to a support arm.

4. The brush as defined in claim 1, wherein the mandrel is configured to distribute the fluid to the polymeric brush body through the plurality of apertures at a substantially constant pressure between different ones of the plurality of apertures, or
wherein the bore is configured to provide the fluid at less than a predetermined pressure gradient from a first end of the mandrel to a second end of the mandrel.

5. The brush as defined in claim 1, wherein the polymeric brush body comprises at least one of a polyvinyl acetal foam, a polyurethane foam, a polyolefin foam, a porous fluoropolymer, a silicone foam, a polyester foam, a nylon foam, or a polyacrylic foam.

6. The brush as defined in claim 1, wherein the polymeric brush body is molded over a brush support, assembled, and then mounted on the brush support, or assembled as a sponge-only brush.

7. The brush as defined in claim 1, further comprising a brush support configured to rotate the polymeric brush body about an axis of the polymeric brush body and a fastener configured to fasten the mandrel to the brush support.

8. The brush as defined in claim 7, wherein the fastener is a clasp, a clip, or a threaded connector.

9. The brush as defined in claim 7, wherein the fastener is arranged between the mandrel and the brush support and comprises a smaller diameter at a first end that interfaces with the mandrel than the diameter of the bore, or
wherein the fastener comprises an inner diameter that is smaller than an inner diameter of the mandrel.

10. A system to clean a substrate, the system comprising:
a cleaning brush, comprising:
a polymeric brush body comprising one or more contact surfaces for cleaning the substrate,
a mandrel configured to support the polymeric brush body, the mandrel comprising:
a plurality of apertures distributed over a surface of the mandrel, and
a bore configured to supply the polymeric brush body with fluid via the plurality of apertures, the bore having a diameter sufficient to supply the plurality of apertures with substantially uniform aperture flow rates for bore flow rates between 200 mL/min and 2 L/min;
a brush support configured to rotate the polymeric brush body about an axis of the polymeric brush body;
a fastener configured to connect the mandrel to the brush support; and
an actuator coupled to the fastener and configured to rotate the polymeric brush body along the axis of the polymeric brush body via the brush support.

11. The system as defined in claim 10, wherein the polymeric brush body is substantially cylindrical and the one or more contact surfaces comprise a plurality of nodules extending from an outer surface of the cylindrical brush body.

12. The system as defined in claim 10, wherein the mandrel is configured to distribute the fluid to the polymeric brush body through the plurality of apertures at less than a predetermined pressure gradient between different ones of the plurality of apertures, or
wherein the bore is configured to provide the fluid at less than a predetermined pressure gradient from a first end of the mandrel to a second end of the mandrel.

13. The system as defined in claim 10, wherein the polymeric brush body comprises at least one of a polyvinyl acetal foam, a polyurethane foam, a polyolefin foam, a porous fluoropolymer, a silicone foam, a polyester foam, a nylon foam, or a polyacrylic foam.

14. The system as defined in claim 10, wherein the polymeric brush body is molded over the brush support, assembled and then mounted on the brush support, or assembled as a sponge-only brush, or
wherein the fastener is a clasp, a clip, or a threaded connector.

15. The system as defined in claim 10, wherein the fastener is arranged between the mandrel and the brush support and comprises a smaller diameter at a first end that interfaces with the mandrel than a second end that interfaces with the brush support, or
wherein the fastener comprises an inner diameter that is smaller than an inner diameter of the mandrel.
